# EUROPEAN PATENT SPECIFICATION

(11) **EP 0 291 034 B1**
(45) Date of publication and mention of the grant of the patent: **29.03.1995**
(21) Application number: 88107555.0
(22) Date of filing: 11.05.1988
(51) Int. Cl.: H01L 39/24

(54) **Method for producing oxide superconductor**
Verfahren zur Herstellung eines supraleitenden Oxyds
Procédé de fabrication d'un oxyde supraconducteur

(30) Priority: 15.05.1987 JP 118215/87; 29.05.1987 JP 133619/87; 29.05.1987 JP 133620/87; 24.08.1987 JP 209878/87; 02.10.1987 JP 249232/87
(43) Date of publication of application: 17.11.1988
(73) Proprietor: MITSUBISHI DENKI KABUSHIKI KAISHA, Tokyo 100 (JP)
(72) Inventor: Nishioka, Katsunori Mitsubishi Denki K.K., Sagamihara-shi Kanagawa-ken (JP); Ishii, Ryoe Mitsubishi Denki K.K., Sagamihara-shi Kanagawa-ken (JP); Mori, Toshihiko Mitsubishi Denki K.K., Sagamihara-shi Kanagawa-ken (JP); Yamagame, Shuichi Mitsubishi Denki K.K., Sagamihara-shi Kanagawa-ken (JP); Taguchi, Osamu Mitsubishi Denki K.K., Sagamihara-shi Kanagawa-ken (JP)
(74) Representative: Liesegang, Roland, Dr.-Ing.

(56) References cited:
- EP-A- 0 288 236
- PATENT ABSTRACTS OF JAPAN, vol. 5, no. 24 (C-43)(696), 13th February 1981; & JP-A-55 149 646
- PHYSICAL REVIEW LETTERS vol. 58, no. 9, 2nd March 1987, pages 908-910; M.K. WU et al.: " Superconductivity at 93 K in a New Mixed-Phase Y-Ba-Cu-O Compound System at Ambient Pressure"
- JAPANESE JOURNAL OF APPLIED PHYSICS vol. 27, no. 1, January 1988, pages L45-L47; K TOGANO et al.: "Superconducting Properties of Ba-Y-Cu-O Tape prepared by the Docotr Blade Process"
- PATENT ABSTRACTS OF JAPAN, vol. 13, no. 109 (E-727)(3457), 15th March 1989; & JP-A-63 279 529

## Description

This invention relates to a method for manufacturing oxide superconductors having high critical temperature. More particularly, it is concerned with a method for producing the oxide superconductors having such property in the form of sheet, filament or coil.

In recent years, there have been many demands on superconductive cables, coils or magnets of low operational cost in the fields of nuclear fusion, electric power such as transmission, magnetically levitated trains, nuclear magnetic resonance device, researches on material properties, and various others.

As the material for such purposes, oxide superconductors having very high critical temperature Tc have recently been discovered. Such superconductive materials exhibit their superconductivity at a temperature as low as that of liquid nitrogen (77K).

This type of oxide superconductors having such high critical temperature Tc, when taking Y-Ba-Cu-O series oxides as an example, can be produced by mixing powder of BaCO₃, Y₂O₃ and CuO, pressforming the mixture, and then heat-treating the shaped body. Incidentally, for this field of technology, reference may be had to, for example, "Phys, Rev. Lett. 58 (1987) pp 908 to 910".

With such method of production, however, there could only be produced a block of such superconductor having its length of a few tens of millimeters at the most, which was too small to be used as an effective magnetic shield. This naturally accompanied points of difficulty such that the superconductive material in block could not be formed into long filament or thin strip which is indispensable for manufacturing the superconductive magnets and cables, and that the oxide superconductive coils of high performance could not be produced.

The present invention has been made with a view to solving the points of problem as mentioned above, and aims at obtaining the oxide superconductive material having high critical temperature and being applicable to magnetic shield, superconductive magnet and electric power transmission cable, which are operable at a higher temperature than ever.

The present invention also aims at providing a method for production of an oxide superconductive coil which is capable of deriving such superconductive coil having a higher critical current density than ever at the liquid nitrogen temperature, hence having a high magnetic field.

According to the present invention in one aspect of it, there is provided a method for production of an oxide superconductor in sheet form as claimed in claim 1, characterized by forming a sheet from a slurry composed of: one or more kinds of powder of oxides, nitrates and carbonates mixed in such a manner as to produce the oxide superconductor by heating, or oxide powder having inherent superconductivity; a resin binder; a plasticizer; and an organic solvent, and then subjecting the thus formed sheet to heat-treatment.

According to the present invention in another aspect of it, there is provided a method for production of an oxide superconductive coil as claimed in claim 9, which comprises steps of: forming a first shaped body in sheet form from a slurry composed of one or more kinds of powder of oxides, nitrates and carbonates mixed in such a manner as to produce the oxide superconductor by heating, or oxide powder having inherent superconductivity; a resin binder; a plasticizer; and an organic solvent, forming a second shaped body in sheet form having insulating property, laminating said first and second shaped bodies in sheet form into a composite shaped body in sheet form, processing said composite shaped body in sheet form and winding the same into a coil form, and subjecting said shaped body in coil form to heat-treatment.

Various ways of carrying out the present invention are described in detail hereinbelow with reference to the accompanying drawings which illustrate the preferred embodiments, in which:-
Figure 1 is a schematic diagram showing an apparatus for manufacturing the oxide superconductor in sheet form, which is employed in the first embodiment of the present invention;
Figure 2 is a schematic diagram showing an apparatus for manufacturing the oxide superconductor in thin strip form, which is employed in the second embodiment of the present invention;
Figure 3 is a schematic diagram showing an apparatus for manufacturing the oxide superconductor in coil form, which is employed in the third embodiment of the present invention;
Figure 4 is a schematic system diagram showing the manufacturing steps for obtaining a shaped body in sheet form according to a different embodiment of the present invention;
Figure 5 is a schematic system diagram showing the steps for producing a composite superconductive sheet in coil form;
Figure 6 is a perspective view showing a composite sheet of the superconductor obtained by the process steps according to the present invention as shown in Figures 4 and 5;
Figure 7 is also a perspective view showing a basic coil to be obtained by another embodiment according to the present invention;
Figure 8 is a schematic diagram showing the steps for producing the first and second shaped body in sheet form according to the another embodiment of the present invention;
Figure 9 is a schematic diagram showing the composite superconductive shaped body in sheet form obtained by the another embodiment of the present invention; and
Figure 10 is a perspective view of an oxide superconductive coil obtained by other embodiment of the present invention.

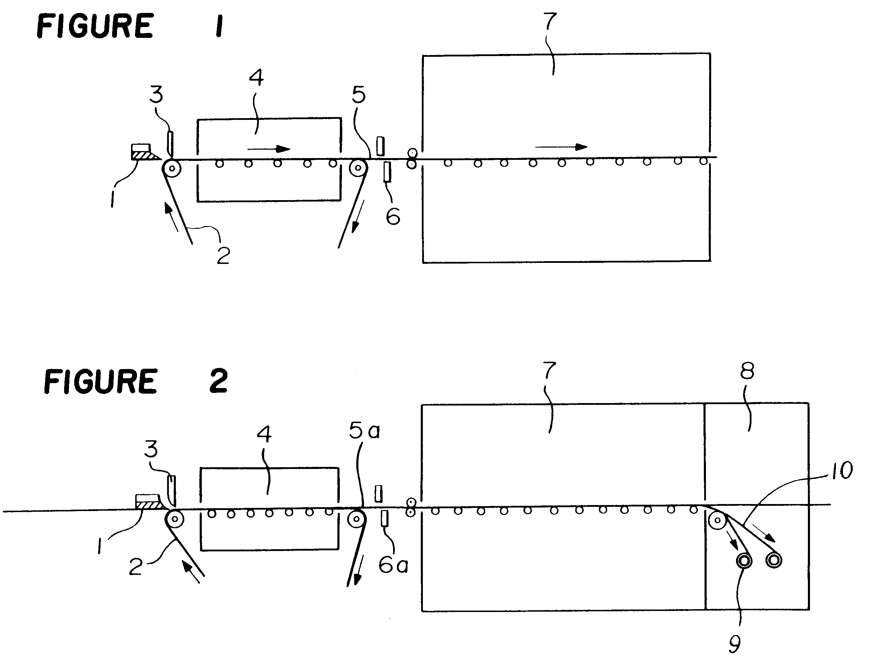

In the following, the present invention will be explained in detail in reference to Figure 1 which schematically illustrates an apparatus for carrying out the production of the oxide superconductor in sheet form according to the first embodiment of the present invention. In the drawing, a reference numeral 1 designates slurry, a numeral 2 refers to a shaping film, 3 denotes a doctor blade, 4 refers to a drying furnace for sheet, 5 indicates a sheet as shaped, 6 a cutter, and 7 a heating furnace. By the way, in this first embodiment of the present invention, the doctor blade method is adopted as the sheet-producing method. In the following, the first embodiment of the present invention will be explained in reference to practical examples.

### EXAMPLE 1

To 1 kg of starting material powders of BaCO₃, Y₂O₃ and CuO (purity: 99.99%, mean particle diameter: approx. 10 »m) which were mixed in such a manner as to have their compositional ratio of (Ba_{0.6}Y_{0.4})₂ CuO₄, there were added 50 g of polyvinyl butyral resin as an organic binder, 30 g of dibutyl phthalate as a plasticizer, and 400 g of a mixture solution of toluene and ethanol as a solvent. Then, the batch was well mixed in a ball mill for 24 hours to prepare a slurry for shaping a sheet.

The thus obtained slurry 1, while it was being poured, was spread by the doctor blade 3 over the entire surface of the shaping film 2 which was rotating in the direction of arrows. The sheet as formed was dried in the drying furnace 4 at a temperature of 100°C for one hour, and the thus dried sheet in web which was continuously sent out of the drying furnace was cut with the cutter 6 to thereby obtain the shaped sheet 5 having a size of 150 mm square and 1.0 mm thick. Subsequently, this sheet 5 was forwarded into the heating furnace 7 in the oxidizing atmosphere to be heated for ten hours at a temperature of 1,100°C to thereby obtain a sintered sheet having 130 mm square and 0.85 mm thick.

When this sintered sheet was cooled down to the temperature of liquid nitrogen, followed by subjecting it to electric conduction test, the flow of superconductive current could be verified. There could also be obtained the magnetic shielding effect, which was difficult to obtain with the conventional superconductors in block form.

### EXAMPLE 2

Nitrate powders of Ba, Y and Cu, which were mixed in such a manner as to have their compositional ratio of (Y_{0.6}Ba_{0.4})₃Cu₂O₇, were subjected to heat-treatment in an atmosphere containing oxygen at a temperature ranging from 600 to 1,100°C, thereby obtaining an oxide. This oxide powder could be verified through measurement of its magnetization to have already attained its superconductivity at this stage. Subsequently, using this oxide powder, a sintered sheet was produced in the same process steps as mentioned in the preceding Example 1. The sintered sheet was then subjected to the electric conduction test, whereupon there could be obtained the results comparable with those in Example 1 above.

### EXAMPLE 3

Starting material powders of BaCO₃, Yb₂O₃ and CuO (having purity of 99.99% and a mean particle diameter of approximately 10 »m), which were mixed in such a manner as to have their compositional ratio of (Yb_{0.6}Ba_{0.4})₃Cu₃O₃, was subjected to heat-treatment at a temperature ranging from 800 to 1,100°C, thereby obtaining oxide powder. In this state as it was, the oxide powder was verified to have already attained its superconductivity, through measurement of its magnetization. Subsequently, using this oxide powder, a sintered sheet was produced in the same process steps as in the above Examples 1 and 2. When the same electric conduction test was carried out on this sintered sheet, there could be obtained the same results as in Examples 1 and 2 above.

As is understandable from the foregoing, according to this first embodiment of the present invention, since the slurry of the oxide superconductive material is formed into a sheet and this sheet material is subjected to heat-treatment, there can be obtained the oxide superconductor in sheet form having a large area, which is usable as the oxide superconductive sheet for the magnetic shielding at high temperature.

Figure 2 is a schematic diagram showing the method for producing ceramic sintered body in filamentary or thin strip form according to the second embodiment of the present invention. In the drawing, the same parts as in the Figure 1 embodiment are designated by the same reference numerals. A reference numeral 6a designates a slitter, a numeral 8 refers to a taking-up furnace, 9 denotes a take-up reel, and 10 a sintered tape.

The method as illustrated in Figure 2 is directed to production of long filamentary ceramic sintered body by first cutting the shaped body in the form of a thin sheet as obtained by the above-described first embodiment into thin strip by means of the slitter, placing the thin strip into a heating furnace of the oxide atmosphere to heat the same at a predetermined heating temperature, and finally taking up the thus sintered strip on the winding reel in its plasticizing temperature range. This second embodiment of the present invention will be described in more detailed hereinbelow with reference to practical examples.

### EXAMPLE 4

In the same manner as in Example 1 above, the slurry 1 was prepared. This slurry 1 was spread over the entire surface of the shaping film 2 by means of the doctor blade 3, while it was being poured thereon. Then, the thus obtained sheet was dried in the sheet-drying furnace 4 at a temperature of 100°C for one hour to thereby obtain the dried sheet 5a having a width of 50 mm and a thickness of 0.5 mm. Subsequently, two thin strips, each having a width of 2.5 mm, were cut out from the center part of the sheet by removing its both side parts, and these long thin strips were subjected to heat-treatment for ten hours in the heating furnace 7 at a temperature of 1,100°C. The resulted sintered strips were then wound up on the take-up reel 9 of alumina in the taking-up furnace 8 at a temperature of 1,000°C by making use of its plasticization. In this manner, there was obtained a long thin strips of sintered material having a length of 10 m and a cross-sectional profile of 2 mm wide and 0.4 mm thick.

A part of this sintered filament (in about 40 mm long) was cooled to the liquid nitrogen temperature and then subjected to the electric conduction test. As the result, there was obtained the superconductive current density of 100 A/cm².

### EXAMPLE 5

In the same manner as in Example 2 above, the oxide powders were prepared. Using these oxide powders, long thin strips of sintered material were produced in the same manner as in Example 4 above, and then the sintered filaments were subjected to the electric conduction test at the liquid nitrogen temperature. As the result, there could be obtained the critical current density which was equal to, or higher than, that of the conventional block sample having the same cross-sectional dimension.

### EXAMPLE 6

In the same manner as in Example 3 above, the oxide powders were prepared. Using these oxide powders, long thin strips of sintered material were produced in the same manner as in Examples 4 and 5 above. The critical current density was also measured on this sintered filament, as the result of which it was found that the sintered filament also exhibited the critical current density which was equal to, or higher than, that of the conventional block sample.

According to the second embodiment of the present invention as has been described in the foregoing, since formation of the long thin strips is carried out by slitting the superconductive sheet formed by the doctor blade method at the stage where it still contains therein the binder, it is relatively easy to obtain long thin strips from the sheet material. Further, in the heat-treatment of the thin strips, the interior of the heating furnace can be adjusted to have the oxidizing atmosphere with the consequence that the shaped body in the form of thin strip can be made a sintered body at a desired heating temperature and a heating atmosphere, which facilitates production of the long filamentary sintered body having excellent properties and high critical temperature.

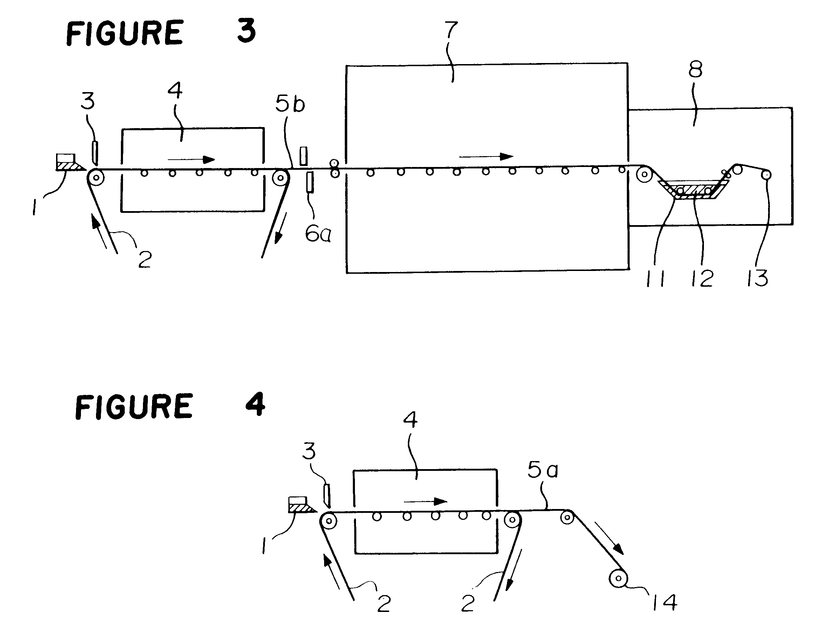

In the following, explanations will be given as to the third embodiment of the present invention, in reference to Figure 3 which illustrates schematically the apparatus for effecting the method for production of the oxide superconductive coil according to this embodiment of the present invention. In the drawing, the same parts as in the Figure 2 embodiment are designated by the same reference numerals. A numeral 11 refers to a glass melting tank, a reference numeral 12 designates molten glass, and 13 a superconductive coil as taken up on a reel.

The method according to this third embodiment is directed to production of a coil of the long filamentary sintered body by first slitting into thin strips the shaped body in sheet form obtained by coating the slurry on the shaping film and drying the thus formed sheet in the drying furnace, then subjecting the thin strip to heat-treatment to render it the sintered body, as already described in the foregoing, subsequently attaching glass material on the surface of this sintered thin strip, and finally winding this sintered thin strip in a coil form at a plasticizing temperature of the sintered body and above the softening temperature of the attached glass material. In the following, the third embodiment of the present invention will be described with reference to practical examples.

### EXAMPLE 7

In the same manner as in Example 1, the slurry 1 was prepared. The slurry was spread, while it was being poured, by the doctor blade 3 over the entire surface of the shaping film 2 which was rotating in the direction of arrows. The sheet as formed was dried in the drying furnace 4 at a temperature of 100°C for one hour, thereby obtaining the sheet 5b having 40 mm in width and 0.4 mm in thickness. Subsequently, both sides of this sheet 5b were removed by means of the slitter 6a to thereby cut out a single strip having a width of 2.5 mm. This strip was placed in the heating furnace 7 of the oxidizing atmosphere to be subjected to the heat-treatment at a temperature of 1,100°C for ten hours, thereby obtaining the sintered thin strip. The thus sintered thin strip was caused to pass through the glass melting tank 11 containing therein the molten glass 12 of Al₂O₃-SiO₂-B₂O₃ series having its melting point of 1,100°C and its softening point of 900°C, thereby attaching the glass material on the surface thereof. Then, the glass-coated sintered strip was wound up in a coil form at a plasticizing temperature of the sintered strip and at a temperature higher than the softening temperature of the attached glass (i.e., 1,000°C).

The resulted wound-up coil 13 had its winding diameter of approximately 30 mm and its winding turn of 50. The sintered strip as wound had its width of 2 mm and thickness of 0.3 mm, with the glass material having been coated on its surface to a thickness of approximately 50 »m.

This coil of the sintered strip was cooled to the liquid nitrogen temperature and then subjected to the electric conduction test, whereupon there was exhibited the superconducting current density as high as 100 A/cm² and the magnetic line of force of several hundreds Tx10⁻⁴ (several hundreds gausses).

### EXAMPLE 8

In the same manner as in Example 2 above, the oxide powders were prepared. Using these oxide powders, a coil of the sintered strip was produced in the same process steps as in Example 7 above. When this coil of the sintered strip was subjected to the electric conduction test at the temperature of liquid nitrogen, there was obtained the result comparable with that of Example 7.

### EXAMPLE 9

In the same manner as in Example 3 above, the oxide powders were prepared. Using these oxide powders, a coil of the sintered strip was produced by the same process steps as in Examples 7 and 8 above. The thus obtained coil of the sintered strip was also subjected to the electric conduction test to obtain the same results as in the above Examples 7 and 8.

As described in the foregoing, according to the third embodiment of the present invention, since the sheet is produced from the slurry of the oxide superconductive material by use of the doctor blade method, and the thus obtained sheet is then cut into the thin strip by means of the slitter, its lengthening becomes easy. Also, since the glass material is attached onto the surface of the sintered thin strip and then it is wound up at a plasticizing temperature of the sintered strip and at a temperature higher than the softening temperature of the attached glass, the insulating film of glass can be formed on the surface of the sintered strip and, at the same time, it can be wound in the coil form in spite of its being brittle. On account of this, it becomes possible to manufacture the coil for the superconductive magnet which can be operated at a high temperature.

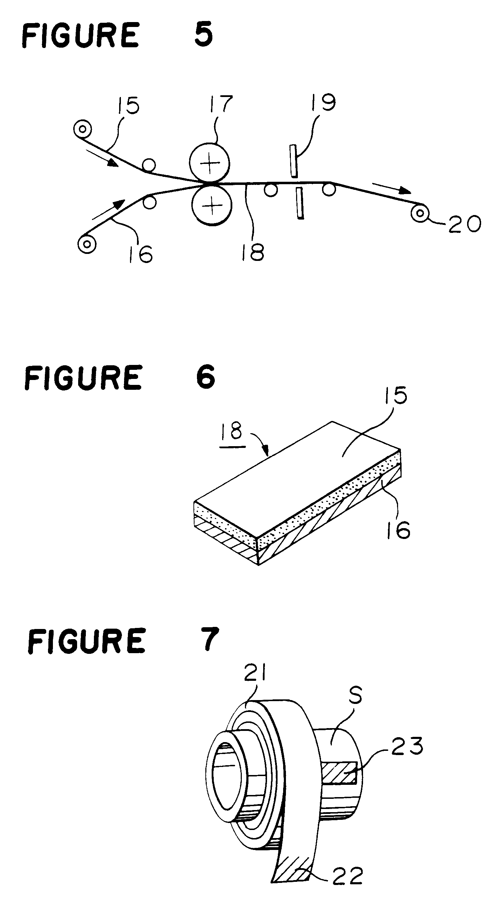

In the following, explanations will be given in reference to Figures 4 and 5 as to one embodiment of the method for producing the superconductive coil which is capable of forming a strong magnetic field.

Figure 4 is a system diagram showing the steps for producing a superconductive sheet according to this embodiment. In the drawing, a numeral 1 refers to the slurry, a reference numeral 2 designates the shaping film, 3 denotes the doctor blade, 4 the drying furnace, 5a the sheet as formed, and 14 the take-up reel.

Figure 5 is also a system diagram showing the steps for producing a composite superconductive sheet in the coil form according to this embodiment. In the drawing, a numeral 15 refers to the superconductive sheet to form the superconductive part by heat-treatment, a reference numeral 16 designates the insulating sheet to form the insulating part by the heat-treatment, a reference numeral 17 represents laminating rollers to assemble both superconductive sheet and insulating sheet, a reference numeral 18 designates a composite sheet as assembled, 19 denotes the slitter, and 20 indicates the thin strip as wound in the coil form.

Figure 6 is a perspective view showing the structure of the composite sheet as obtained by this embodiment.

In the following, the production of the oxide superconductive coil will be explained in reference to a practical example.

### EXAMPLE 10

The slurry 1 was prepared by uniformly mixing in a ball mill polyvinyl butyral as the binder, dibutyl phthalate as the plasticizer, mixed liquid of toluene and ethanol as the solvent, and the starting material powder of BaCO₃, Y₂O₃ and CuO (carbonate and oxide) which were mixed in such a manner that the compositional ratio thereof might be (Ba_{0.6}Y_{0.4})₂CuO₄.

From this slurry 1, there was formed the superconductive sheet 5a on the shaping film 2 by means of the doctor blade 3 to thereby obtain the superconductive sheet 15 having a width of 100 mm and a thickness of 0.2 mm. This superconductive sheet was dried in the sheet-drying furnace 4, followed by peeling it off the shaping film 2 to be wound on the take-up reel 14. Separate from this, another sheet 5a as the insulating sheet 16 having the same dimension as the superconductive sheet was produced by use of alumina powder.

The thus obtained superconductive sheet 15 and the insulating sheet 16 were put together through the laminating rolls 17, as shown in Figure 5, which were kept at their surface temperature of 120°C and nipping pressure of 200 kg/cm², thereby forming the composite sheet 18 of the structure as shown in Figure 6. From this composite sheet 18, there was cut out by the slitter 19 two thin strips, each having a width of 2.5 mm, which were wound simultaneously on and around an alumina pipe having an outer diameter of 50 mm and a length of 100 mm from one end to the other, thereby obtaining two coils of thin strips 20. Subsequently, these coiled strips were put in the heating furnace to subject them to heat-treatment at a temperature of 1,100°C for five hours, thereby manufacturing the superconductive coils. The coils were then cooled to the liquid nitrogen temperature and measured its critical current value. It was found that the current density of the coiled strips was 1,100 A/cm². This value, when compared with the coils obtained by the conventional metal pipe stretching method, was sufficiently high.

On the other hand, as regards the insulating sheet to form the composite sheet, there may be used, besides the alumina sheet, any other material, provided that it has the insulating property in at least its sintered state, reinforces the mechanical property of the superconductive ceramic, and does not deteriorate the properties of the superconductor due to reaction with it, and so on. Also, the method of producing the superconductive strip in coil form is not limited to that of this example.

As described in the foregoing, since the embodiment according to the present invention is capable of carrying out various processes such as slitting the superconductive sheet into thin strips, while it still contains the binder therein, winding the thin strips in the coil form, and so on, and also capable of reinforcing the mechanical strength of the sintered superconductive strips by its combination with the separately formed insulating ceramic strip, there can be accrued various advantages such that the fragile and breakable ceramic superconductive material can be formed relatively easily into filament as well as into coil, that sufficient amount of oxygen can be fed to the superconductive material in powder at the time of heating the same to thereby enable the superconductor having excellent properties to be obtained, and further that, in forming the thin strip into coil, the insulating layer which has been combined to form the composite sheet effectively works as the interlayer for insulation, and others.

In the following, another embodiment of the method for production of the oxide superconductive coil according to the present invention will be explained.

Figure 7 is a perspective view showing a basic coil of various oxide superconductive coils obtained by this embodiment, in which a reference numeral 21 designates a coiled part formed by winding the thin strip of the superconductive material in predetermined number of winding turns on a take-up core S, and numerals 22 and 23 refer to electrode terminals.

Figure 8 is a schematic diagram showing the steps for producing both first and second shaped body in sheet form according to this another embodiment by the doctor blade method.

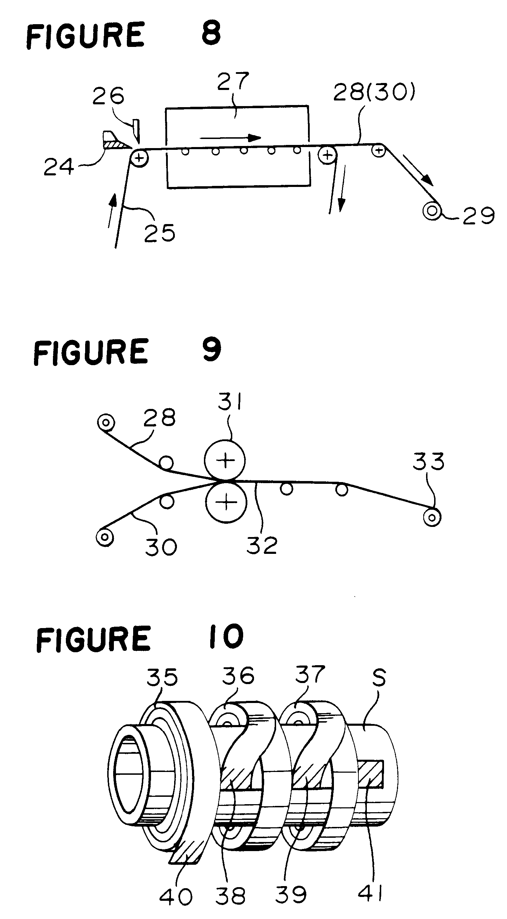

Figure 9 is also a schematic diagram showing the steps for producing the composite shaped body in sheet form according to this embodiment. The following is a practical example of how the coil of the superconductive material can be obtained by this embodiment.

### EXAMPLE 11

The slurry 24 was prepared by uniformly mixing in a ball mill polyvinyl butyral as the binder, dimethyl phthalate as the plasticizer, mixed liquid of toluene and ethanol as the solvent, and the starting material powders of BaCO₃, Y₂O₃ and CuO (carbonate and oxide) which were mixed in such a manner as to have the compositional ratio of YBa₂Cu₃. Subsequently, this slurry 24 was poured onto the surface of the shaping film 25 and formed by means of the doctor blade 26 into the first sheet (superconductive sheet) 28 having width of 120 mm and thickness of 0.2 mm. Then, this sheet was caused to pass through the drying furnace 27 to be dried, followed by winding the same on the take-up reel 29. Separate from this, another slurry was prepared in the same manner as mentioned above by use of alumina powder. This separate slurry was also formed into the second sheet (insulating sheet) 30 of the same size as that of the first sheet, which was also dried in the drying furnace and wound on the take-up reel.

Subsequently, both first and second sheets 28, 30 were laminated, as shown in Figure 9, through the laminating rollers 31 maintained at its surface temperature of 120°C and nipping pressure of 200 kg/cm², thereby combining them into a composite sheet. The thus obtained composite sheet 32 was taken up on the alumina winding core S for 50 winding turns, with the insulating sheet 30 facing inside. Then, as shown in Figure 7, this composite sheet 33 as wound was slit into individual coil 21 having a width of 2 mm. At that time, one of the electrode terminal parts 23 was left to be in contact with the winding core S. Then, this coil was put in the heating furnace to be subjected to heat-treatment in the oxidizing atmosphere at a temperature of 1,000°C for 15 hours, thereby producing the oxide superconductive coil (basic coil).

This coil was cooled to the liquid nitrogen temperature, and then measured its critical current value. A critical current density of 1,100 A/cm² was obtained. This value was sufficiently high in comparison with the coil obtained by the conventional metal pipe stretching method.

In the above-described embodiment, since the flexible composite sheet 32 is wound in the coil form prior to its heat-treatment, while still containing therein the binder, and then cut into strips of narrow width, followed by heating the same as it is, the oxide superconductor, which is brittle and therefore difficult to wind in the coil form, can be formed relatively easily into such coil form with the consequence that there is no need for using the sheath which has conventionally been employed.

Further, since no sheath is required to be used, there is no necessity for taking into consideration the influence of the sheath material on the superconductive material at the time of the heat-treatment, whereby the optimum heating temperature and heating atmosphere (oxidizing atmosphere) can be selected. On account of this, there can be obtained the oxide superconductive coil having excellent electrical and magnetic properties, as already mentioned in the foregoing.

Furthermore, since the second sheet (insulating sheet) 30 is taken up in the coil form by being laminated on the first superconductive sheet 28, it not only contributes to improvement in the mechanical strength of the coil, but also functions as the interlayer insulating member for the oxide superconductive layer which has been formed into the coil, after completion of the heat-treatment.

Figure 10 illustrates other example of the oxide superconductive coil obtained by the method of production according to the present invention, in which three coils 35, 36 and 37 of the oxide superconductor are connected in series at their connecting parts 38 and 39 to construct a connected coil. The connecting part 38 is for the adjacent coils 35 and 36, while the connecting part 39 is for the adjacent coils 36 and 37. Reference numerals 40 and 41 designate the electrode terminal parts.

This connected coil can be manufactured in the following manner. First of all, the composite sheet 32 is wound on and around the winding core S with the insulating sheet 30 facing inside, followed by slitting it into three pieces of coils 35, 36 and 37. At that time, the coils 35, 36 and 36, 37 should be perfectly separated. Subsequently, the starting end for winding of the coil 35 and the finishing end for winding of the coil 36 are overlapped each other at the connecting part 38, and then, after the adhering surfaces of the overlapped ends are wetted with a solvent for the sheet binder, they are glued together under pressure. In this instance, in order to enable the end surfaces of the superconductive coils to be mutually adhered, the insulating sheet 30 at the finishing end for winding of the coil 36 should be removed. The same procedures are followed for connecting the coils 36 and 37. After completion of the connection among these three pieces of coils 35, 36 and 37, they are subjected to heat-treatment as is the case with the basic coil shown in Figure 7, whereby the connected coil of the oxide superconductor can be obtained.

In this manner, when a plurality of coils of the oxide superconductor is connected in series, it becomes possible to manufacture the oxide superconductive coils having increased number of winding turns.

In this embodiment, too, as is the case with the embodiments in Figures 4 to 6, the insulating sheet for producing the composite sheet may be made of any materials other than alumina, provided that they have sufficient insulating property, reinforce the mechanical property of the superconductor, and do not deteriorate the properties of the superconductor due to reaction with it, and so forth.

As has been described in the foregoing, since, according to this embodiment of the present invention, the first sheet to be the oxide superconductive layer and the second sheet to be the insulating layer are laminated and wound in the coil form, while they still contain the binder and are flexible, and then this composite sheet is slit into thin strips, followed by heating the same, there can be obtained relatively easily the oxide superconductor in coil form, which is primarily difficult to be coiled, without using those sheath materials which are liable to deteriorate the properties of the oxide superconductor or those expensive sheath materials.

Further, since no sheath material is employed, there is no necessity for taking into consideration the influence of the sheath material on the superconductive material at the time of the heat-treatment. On account of this, it becomes possible to carry out the heat-treatment in the optimum heating atmosphere and at the optimum heating temperature with the consequence that the oxide superconductive coil of excellent electrical and magnetic properties can be obtained.

Further, since the second sheet is laminated on the first sheet, the resulting oxide superconductive coil is excellent in its mechanical strength and insulating property.

In each of the afore-described examples, use is made of the Y-Ba-Cu-O and Yb-Ba-Cu-O series oxides. It should however be noted that other oxide superconductors having high critical temperature than those above-mentioned may also be used for the purpose of the present invention. Examples of such oxides are Sc-Ba-Cu-O series or La-Sr-Cu-O series. That is to say, the oxide superconductors according to the present invention are those composed of various elements containing therein M₁, M₂, Cu and O (where: M₁ is the group IIIa element and M₂ is the Group IIa element). For the Group IIIa element, there may be used one or more kinds of La, Y, Yb Sc, Ce, Pr, Sm, Ho, Er and Tm. For the Group IIa element, there may be used one or more kinds of Ba, Sr, Ca and Mg.

To add more, the starting material powder according to the present invention is not limited to oxides, carbonates, nitrates and so forth which do not exhibit superconductivity, but any oxide powder which already possesses the superconductivity. By the way, in the afore-described examples, the starting materials are a combination of oxide and carbonate, or nitrate alone, although oxide alone may of course be used, if a stable oxide can be obtained.

Furthermore, the heat-treatment is carried out in the oxygen-containing atmosphere, as has already been mentioned in the foregoing, for the purpose of which the heating temperature is selected in a range of from 600 to 1,500°C, because, below 600°C, carbonate does not decompose, while, above 1,500°C, oxide becomes unstable.

Further, in each of the above-mentioned examples, the doctor blade method is adopted as the sheet producing method. It is of course possible to employ the injection molding method for the sheet production with the same effect as mentioned in the foregoing.

## Claims

1. A method to produce an oxide superconductor, comprising the steps of
forming a sheet (5) from a slurry (1) prepared from a mixture of one or more kinds of powders of oxides, nitrates and carbonates mixed in a composition ratio which can be rendered superconducting by heat-treatment in oxidizing atmosphere, a resin binder, a plasticizer and an organic solvent;
spreading the slurry (1) over a film (2);
drying the resulting sheet (5) and;
subjecting it to a heat-treatment in an oxidizing atmosphere, thereby producing the oxide superconductor.

2. The method to produce an oxide superconductor in sheet form according to claim 1, characterized in that the sheet (5) is formed by the doctor blade method.

3. The method to produce an oxide superconductor in sheet form according to claim 1 or 2, characterized in that the sheet (5) is heat-treated in an oxygen-containing atmosphere at a temperature in a range of from 600°C to 1,500°C.

4. The method to produce an oxide superconductor in sheet form according to claim 1, characterized in that said oxide superconductor is an oxide consisting of elements including M₁, M₂, Cu and O, wherein M₁ is a Group IIIa element and M₂ is a Group IIa element.

5. The method to produce an oxide superconductor in sheet form according to claim 4, characterized in that said Group IIIa element is one or more kinds selected from La, Y, Yb, Ce, Pr, Ho, Er, Sm, Tm and Sc.

6. The method to produce an oxide superconductor in sheet form according to claim 4 or 5, characterized in that said Group IIa element is one or more kinds selected from Sr, Ba, Ca and Mg.

7. The method to produce an oxide superconductor in sheet form according to any one of the preceding claims, characterized in that the sheet (5) is produced from said slurry (1) by means of the doctor blade method, that, after said sheet (5) is slit into a thin strip, it is heat-treated to be a sintered body, and that the sintered thin strip is wound on and around a take-up reel (9) at the plasticizing temperature of said sintered body.

8. The method to produce an oxide superconductor in sheet form according to any one of claims 1 to 6, characterized in that the sheet (5) is produced from said slurry (1) by means of the doctor blade method, that, after said sheet (5) is slit into a thin strip, it is heat-treated to be a sintered body, that glass coating material (12) is adhered onto the surface of said sintered thin strip (5), and that said glass-coated sintered thin strip is wound in a coil form at a plasticizing temperature of the sintered body and at a temperature above the softening temperature of the adhered glass coating material (12).

9. A method to produce an oxide superconductive coil comprising the steps of:
forming a first body (28) in sheet form from a slurry (24) prepared by mixing a resin binder, a plasticizer, an organic solvent and a mixture of one or more kinds of powders of oxides, nitrates and carbonates in such a compositional ratio that it can be rendered superconducting by a heat-treatment in an oxidizing atmosphere;
forming a second and insulating body (30) in sheet form in the same manner as the first body (28) was formed but with the addition of alumina powder;
laminating said first and second shaped bodies (28, 30) into a composite shaped body (32) in sheet form;
winding said composite sheet form (32);
slitting said wound composite (32) into individual coil (21);
subjecting said coil (21) to a heat-treatment in an oxidizing atmosphere, thereby producing the oxide superconducting coil.

10. The method to produce an oxide superconductive coil according to claim 9, characterized in that said composite shaped body in sheet form (32) is slit into a thin strip.

11. The method to produce an oxide superconductive coil according to any one of claims 9 or 10, characterized in that said thin strip wound in the coil form (21) is subjected to heat-treatment in an oxygen-containing atmosphere at a temperature in a range of from 600°C to 1,500°C.

12. The method to produce an oxide superconductive coil according to claim 9, characterized in that said second shaped body in sheet form (30) is formed from a slurry (24) containing the alumina powder exhibiting the insulating property, a resin binder, a plasticizer and a solvent, and that said composite shaped body in sheet form (32), after it has been wound, is slit into a thin strip to be a coil of narrow width (21).

13. The method to produce an oxide superconductive coil according to claim 12, characterized in that said composite shaped body in sheet form (32) as wound is slit into two or more thin strips in coil form (35,36,37) and then said coils (35,36,37) are connected in series to be the composite shaped body in sheet form as wound containing therein two or more coil parts.

## Patentansprüche

1. Verfahren zum Herstellen eines Oxid-Supraleiters, welches die folgenden Schritte umfaßt:
Bilden einer Schicht (5) aus einem Brei (1), der aus einer Mischung aus einer oder mehreren Arten von Pulvern von Oxiden, Nitraten und Karbonaten, die in einem Anteilsverhältnis vermischt sind, das durch eine Wärmebehandlung in einer oxidierenden Umgebung supraleitend gemacht werden kann, einem Harz-Bindemittel, einem Weichmacher und einem organischen Lösungsmittel hergestellt worden ist,
Verteilen des Breis (1) auf einem Film (2),
Trocknen der resultierenden Schicht (5) und
Unterziehen derselben unter eine Wärmebehandlung in einer oxidierenden Umgebung, wodurch der Oxid-Supraleiter hergestellt wird.

2. Verfahren zum Herstellen eines Oxid-Supraleiters in Schichtform nach Anspruch 1, dadurch gekennzeichnet, daß die Schicht (5) mit dem Streichmesser-Verfahren hergestellt wird.

3. Verfahren zum Herstellen eines Oxid-Supraleiters in Schichtform nach Anspruch 1 oder 2, dadurch gekennzeichnet, daß die Schicht (5) in einer sauerstoffhaltigen Umgebung bei einer Temperatur in einem Bereich von 600°C bis 1500°C wärmebehandelt wird.

4. Verfahren zum Herstellen eines Oxid-Supraleiters in Schichtform nach Anspruch 1, dadurch gekennzeichnet, daß der Oxid-Supraleiter ein Oxid ist, welches aus Elementen besteht, die M₁, M₂, Cu und O umfassen, wobei M₁ ein Element aus der Gruppe IIIa und M₂ ein Element aus der Gruppe IIa ist.

5. Verfahren zum Herstellen eines Oxid-Supraleiter in Schichtform nach Anspruch 4, dadurch gekennzeichnet, daß das Element aus der Gruppe IIIa aus einer oder mehreren Arten besteht, die aus La, Y, Yb, Ce, Pr, Ho, Er, Sm, Tm und Sc ausgewählt sind.

6. Verfahren zum Herstellen eines Oxid-Supraleiters in Schichtform nach Anspruch 4 oder 5, dadurch gekennzeichnet, daß das Element aus der Gruppe IIa aus einer oder mehreren Arten besteht, die aus Sr, Ba, Ca und Mg ausgewählt sind.

7. Verfahren zum Herstellen eines Oxid-Supraleiters in Schichtform nach einem der vorangehenden Ansprüche, dadurch gekennzeichnet, daß die Schicht (5) aus dem Brei (1) mit dem Streichmesser-Verfahren hergestellt wird, daß die Schicht (5), nachdem sie zu einem dünnen Streifen geschlitzt worden ist, wärmebehandelt wird, so daß sie ein gesinterter Körper ist, und daß der gesinterte dünne Streifen auf und um eine Aufwikkelrolle (9) bei der Plastifizierungstemperatur des gesinterten Körpers gewickelt wird.

8. Verfahren zum Herstellen eines Oxid-Supraleiters in Schichtform nach einem der Ansprüche 1 bis 6, dadurch gekennzeichnet, daß die Schicht (5) aus dem Brei (1) mit dem Streichmesser-Verfahren hergestellt wird, daß die Schicht (5), nachdem sie zu einem dünnen Streifen geschlitzt worden ist, wärmebehandelt wird, so daß sie ein gesinterter Körper ist, daß ein Glas-Beschichtungsmaterial (12) an der Oberfläche des gesinterten dünnen Streifens (5) zum Anhaften gebracht wird, und daß der glasbeschichtete, gesinterte dünne Streifen in einer Spulenform bei einer Plastifizierungstemperatur des gesinterten Körpers und einer Temperatur oberhalb der Erweichungstemperatur des anhaftenden Glas-Beschichtungsmaterials (12) aufgewickelt wird.

9. Verfahren zum Herstellen einer Oxid-Supraleiter-Spule, welches die folgenden Schritte umfaßt:
Bilden eines ersten Körpers (28) in Schichtform aus einem Brei (24), der durch Mischen eines Harz-Bindemittels, eines Weichmachers, eines organischen Lösungsmittels und einer Mischung aus einer oder mehreren Arten von Pulvern von Oxiden, Nitraten und Karbonaten in einem solchen Anteilsverhältnis, daß sie durch eine Wärmebehandlung in einer oxidierenden Umgebung supraleitend gemacht werden kann, hergestellt worden ist,
Bilden eines zweiten, isolierenden Körpers (30) in Schichtform in derselben Weise, in der der erste Körper (28) gebildet wurde, jedoch mit dem Zusatz von Aluminiumoxid-Pulver,
Laminieren des ersten und des zweiten geformten Körpers (28, 30) zu einem zusammengesetzten geformten Körper (32) in Schichtform,
Wickeln dieser zusammengesetzten Schichtform (32),
Schlitzen des gewickelten Schichtkörpers (32) zu einer individuellen Spule (21),
Unterziehen der Spule (21) unter eine Wärmebehandlung in einer oxidierenden Umgebung, wodurch die Oxid-Supraleiter-Spule hergestellt wird.

10. Verfahren zum Herstellen einer Oxid-Supraleiter-Spule nach Anspruch 9, dadurch gekennzeichnet, daß der zusammengesetzte geformte Körper in Schichtform (32) zu einem dünnen Streifen geschlitzt wird.

11. Verfahren zum Herstellen einer Oxid-Supraleiter-Spule nach einem der Ansprüche 9 oder 10, dadurch gekennzeichnet, daß der dünne, in Spulenform gewickelte Streifen (21) einer Wärmebehandlung in einer sauerstoffhaltigen Umgebung bei einer Temperatur in einem Bereich von 600°C bis 1500°C unterzogen wird.

12. Verfahren zum Herstellen einer Oxid-Supraleiter-Spule nach Anspruch 9, dadurch gekennzeichnet, daß der zweite geformte Körper in Schichtform (30) aus einem Brei (24) gebildet wird, welcher Aluminiumoxid-Pulver, das die isolierende Eigenschaft aufweist, ein Harz-Bindemittel, einen Weichmacher und ein Lösungsmittel enthält, und daß der zusammengesetzte geformte Körper in Schichtform (32), nachdem er gewickelt worden ist, zu einem dünnen Streifen geschlitzt wird, so daß er eine Spule mit geringer Breite (21) ist.

13. Verfahren zum Herstellen einer Oxid-Supraleiter-Spule nach Anspruch 12, dadurch gekennzeichnet, daß der zusammengesetzte geformte Körper in Schichtform (32) im gewickelten Zustand zu zwei oder mehreren dünnen Streifen in Spulenform (35, 36, 37) geschlitzt wird und daß dann diese Spulen (35, 36, 37) in Reihe geschaltet werden, so daß sie der zusammengesetzte geformte Körper in Schichtform in gewickeltem Zustand, der zwei oder mehrere Spulenteile enthält, sind.

## Revendications

1. Procédé pour produire un oxyde supraconducteur, comprenant les étapes consistant à:
former une feuille (5) à partir d'une suspension épaisse (1) préparée avec un mélange d'une ou plusieurs sortes de poudres d'oxydes, de nitrates et de carbonates mélangées dans un rapport de composition et qui peut être rendue supraconductrice par un traitement à la chaleur dans une atmosphère oxydante, un liant résineux, un plastifiant et un dissolvant organique;
répandre la suspension épaisse (1) sur un film (2);
sécher la feuille résultante (5); et
soumettre la feuille à un traitement à la chaleur dans une atmosphère oxydante, afin de produire ainsi l'oxyde supraconducteur.

2. Procédé pour produire un oxyde supraconducteur sous forme de feuille selon la revendication 1, caractérisé en ce que la feuille (5) est formée par le procédé de la raclette.

3. Procédé pour produire un oxyde supraconducteur sous forme de feuille selon la revendication 1 ou 2, caractérisé en ce que la feuille (5) est traitée à la chaleur dans une atmosphère contenant de l'oxygène à une température dans une plage de 600 °C à 1500 °C.

4. Procédé pour produire un oxyde supraconducteur sous forme de feuille selon la revendication 1, caractérisé en ce que ledit oxyde supraconducteur est un oxyde composé d'éléments incluant M₁, M₂, Cu et O parmi lesquels M₁ est un élément du Groupe IIIa et M₂ est un élément du Groupe IIa.

5. Procédé pour produire un oxyde supraconducteur sous forme de feuille selon la revendication 4, caractérisé en ce que ledit élément du groupe IIIa est constitué par une ou plusieurs sortes d'éléments sélectionnés parmi La, Y, Yb, Ce, Pr, Ho, Er, Sm, Tm et Sc.

6. Procédé pour produire un oxyde supraconducteur sous forme de feuille selon la revendication 4 ou 5, caractérisé en ce que ledit élément du groupe lIa est constitué par une ou plusieurs sortes d'éléments sélectionnés parmi Sr, Ba, Ca et Mg.

7. Procédé pour produire un oxyde supraconducteur sous forme de feuille selon l'une quelconque des revendications précédentes, caractérisé en ce que la feuille (5) est produite à partir de ladite suspension épaisse (1) au moyen du procédé de la raclette, en ce que, après que ladite feuille (5) ait été fendue en un ruban mince, elle est traitée à la chaleur pour constituer un corps fritté, et en ce que le ruban mince fritté est enroulé sur une bobine réceptrice (9) et autour de celle-ci à la température de plastification dudit corps fritté.

8. Procédé pour produire un oxyde supraconducteur sous forme de feuille selon l'une quelconque des revendications 1 à 6, caractérisé en ce que la feuille (5) est produite à partir de ladite suspension épaisse (1) au moyen du procédé de la raclette, en ce que, après que ladite feuille (5) ait été fendue en un ruban mince, elle est traitée à la chaleur pour constituer un corps fritté, en ce qu'un matériau de revêtement de vitrification (12) est déposé et adhère à la surface dudit ruban mince fritté (5), et en ce que ledit ruban mince fritté et vitrifié est enroulé sous une forme en bobine à une température de plastification du corps fritté et à une température au-dessus de la température de déformation du matériau de revêtement vitrifié et adhérant (12).

9. Procédé pour produire une bobine supraconductrice d'oxyde comprenant les étapes consistant à:
former un premier corps (28) sous forme de feuille à partir d'une suspension épaisse (24) préparée en mélangeant un liant résineux, un plastifiant, un dissolvant organique et un mélange d'une ou plusieurs sortes de poudres d'oxydes, de nitrates et de carbonates avec un rapport de composition tel qu'elle peut être rendue supraconductrice par un traitement à la chaleur dans une atmosphère oxydante;
former un second corps (30), isolant et sous forme de feuille, de la même manière que le premier corps (28) a été formé mais avec l'addition d'une poudre d'alumine;
superposer en couches lesdits premier et second corps façonnés (28, 30) en un corps façonné composite (32) sous forme de feuille;
enrouler ladite forme composite en feuille (32);
fendre ledit composite enroulé (32) en une bobine individuelle (21);
soumettre ladite bobine (21) à un traitement à la chaleur dans une atmosphère oxydante, afin de produire ainsi une bobine supraconductrice d'oxyde.

10. Procédé pour produire une bobine supraconductrice d'oxyde selon la revendication 9, caractérisé en ce que ledit corps façonné composite sous forme de feuille (32) est fendu en un ruban mince.

11. Procédé pour produire une bobine supraconductrice d'oxyde selon l'une quelconque des revendications 9 ou 10, caractérisé en ce que ledit ruban mince enroulé dans la forme en bobine (21) est soumis à un traitement à la chaleur dans une atmosphère contenant de l'oxygène à une température dans une plage de 600 °C à 1500°C.

12. Procédé pour produire une bobine supraconductrice d'oxyde selon la revendication 9, caractérisé en ce que ledit second corps façonné sous forme de feuille (30) est formé à partir d'une suspension épaisse (24) contenant une poudre d'alumine présentant une propriété isolante, un liant résineux, un plastifiant et un dissolvant, et en ce que ledit corps façonné composite sous forme de feuille (32), après avoir été enroulé, est fendu en une mince bande afin de constituer une bobine de largeur étroite (21).

13. Procédé pour produire une bobine supraconductrice d'oxyde selon la revendication 12, caractérisé en ce que ledit corps façonné composite sous forme de feuille (32), alors qu'il est enroulé, est fendu en deux rubans minces ou plus dans une forme en bobine (35, 36, 37), et, ensuite, lesdites bobines (35, 36, 37) sont reliées en série pour constituer le corps façonné composite sous forme de feuille, alors qu'il est enroulé, en comprenant deux parties de bobine ou plus.
